# EUROPEAN PATENT APPLICATION

(11) **EP 4 827 298 A2**
(43) Date of publication of application: **21.10.2026**
(21) Application number: 26195263.4
(22) Date of filing: 29.07.2026
(51) Int. Cl.: H10K 59/80, H10K 59/65

(54) **DISPLAY PANEL AND DISPLAY DEVICE**

(30) Priority: 28.04.2026 CN 202610574539
(71) Applicant: Wuhan China Star Optoelectronics Semiconductor Display Technology Co., Ltd., Wuhan, Hubei 430079 (CN)
(72) Inventor: Ma, Ling, 430079 Wuhan, Hubei (CN)
(74) Representative: Berggren Oy

(57) **Abstract**

A display panel and a display device are provided. In the display panel (1), at least one of a second refractive index layer (282), a first planarization layer (290), and a second planarization layer (295) is provided with a first through hole (33), the first through hole (33) is disposed in a functional region (103) and a transition region (104), and a boundary of the first through hole (33) is located in the transition region (104), so that an internal stress between adjacent film layers can be reduced, an internal stress conducted to a lower film layer can be reduced, and a risk of peeling off a light-emitting material layer (253) and a common electrode layer (254) can be reduced, thereby reducing the risk of water and oxygen intrusion, improving the encapsulation effect, and improving reliability of the display panel (1).

## Description

### TECHNICAL FIELD

The invention relates to display technologies, and in particular to a display panel and a display device.

### BACKGROUND

Organic light-emitting diode (OLED) display devices are widely used due to their advantages of selfluminescence and flexibility. In order to achieve the anti-peeping function, the existing OLED display device is provided with anti-peeping pixels and non-anti-peeping pixels, and anti-peeping is achieved by blocking light of a wide viewing angle of the anti-peeping pixels and matching different display modes. However, in the actual use process, it is found that there is a problem of film peeling in the display panel, resulting in intrusion of water and oxygen from the film peeling position, which in turn results in encapsulation failure.

Therefore, the existing OLED display device has the technical problem of encapsulation failure caused by film peeling.

### SUMMARY

The invention is set out in the appended set of claims.

Embodiments of the invention provide a display panel and a display device, so as to solve the technical problem of encapsulation failure caused by film peeling of the existing OLED display device.

In order to achieve the above object, according to a first aspect of the invention, a display panel is provided, the display panel includes a display region, a functional region and a transition region, and the transition region is disposed between the display region and the functional region. The display panel includes a substrate and a dimming functional layer, a first light-shielding layer, a first planarization layer, a second light-shielding layer, and a second planarization layer disposed on a side of the substrate. The dimming functional layer includes a first refractive index layer and a second refractive index layer, the first refractive index layer is disposed between the substrate and the second refractive index layer, and a refractive index of the first refractive index layer is less than a refractive index of the second refractive index layer. At least one of the second refractive index layer, the first planarization layer, and the second planarization layer is provided with a first through hole, the first through hole is disposed in the functional region and the transition region, and a boundary of the first through hole is located in the transition region.

According to a second aspect of the invention, a display device including the above display panel is provided.

Embodiments of the invention provide a display panel and a display device. In the display panel, at least one of a second refractive index layer, a first planarization layer, and a second planarization layer is provided with a first through hole, the first through hole is disposed in a functional region and a transition region, and a boundary of the first through hole is located in the transition region, so that an internal stress between adjacent film layers can be reduced, an internal stress conducted to a lower film layer can be reduced, and a risk of peeling off a light-emitting material layer and a common electrode layer can be reduced, thereby reducing the risk of water and oxygen intrusion, improving the encapsulation effect, and improving reliability of the display panel.

Other features and advantages of the invention will be described in detail in the following detailed description.

### BRIEF DESCRIPTION OF THE DRAWINGS

In order to explain the technical solutions in the embodiments of the invention more clearly, the accompanying drawings required in the description of the embodiments will be briefly introduced below. It will be apparent that the accompanying drawings in the following description are merely some embodiments of the invention, and other drawings can be obtained by those skilled in the art based on these drawings without creative efforts.

In order to fully understand the invention and beneficial effects thereof, the description will be given below in conjunction with the drawings, and the same reference signs in the description below indicate the same parts in the drawings.
FIG. 1 is a schematic plan view of a display panel according to some embodiments of the invention.
FIG. 2 is a pixel arrangement view of a display panel according to some embodiments of the invention.
FIG. 3 is a first schematic cross-sectional view along line A1-A2 of the display panel in FIG. 1.
FIG. 4 is a schematic cross-sectional view of some film layers in a display region of a display panel according to some embodiments of the invention.
FIG. 5 is a first schematic cross-sectional view of a display panel according to some embodiments of the invention.
FIG. 6 is a second schematic cross-sectional view of a display panel according to some embodiments of the invention.
FIG. 7 is a third schematic cross-sectional view of a display panel according to some embodiments of the invention.
FIG. 8A and FIG. 8B are schematic plan views of a first through hole, a second through hole, a third through hole of a display panel according to some embodiments of the invention.
FIG. 9 is a first schematic cross-sectional view of a display region of a display panel according to some embodiments of the invention.
FIG. 10 is a second schematic cross-sectional view of a display region of a display panel according to some embodiments of the invention.
FIG. 11 is a second schematic cross-sectional view along line A1-A2 of the display panel of FIG. 1.

### DETAILED DESCRIPTION

A clear and complete description of the technical solutions in the embodiments of the invention will be given in conjunction with the accompanying drawings in the embodiments of the invention. It will be apparent that the described embodiments are only a part of the examples of the invention, and not all examples. Based on the embodiments in the invention, all other embodiments obtained by those skilled in the art without making creative efforts fall within the scope of protection of the invention.

The embodiments of the invention provide a display panel and a display device to solve the technical problem of encapsulation failure caused by film peeling of the existing OLED display device.

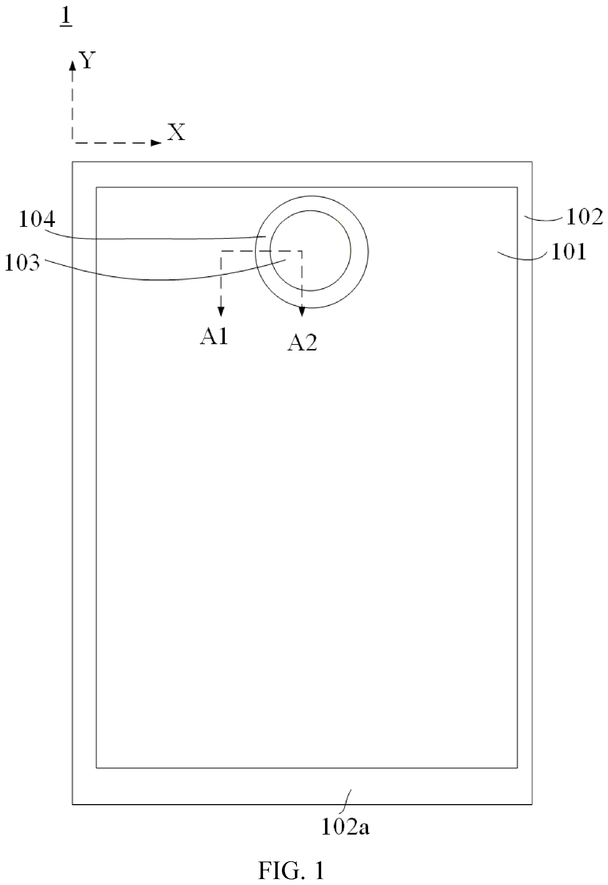

As shown in FIG. 1, embodiments of the invention provides a display panel, and the display panel 1 includes a display region 101, a non-display region 102, a functional region 103, and a transition region 104. Sub-pixels may be arranged in the display region 101, structures such as gate driving circuits and bonding terminals may be arranged in the non-display region 102, functional elements may be arranged in the functional region 103, and the transition region 104 may be used as an encapsulation region to prevent water and oxygen from invading, and may be used as a winding region to realize the connection of wires on both sides or around the functional region 103.

Specifically, in FIG. 1, an example in which the non-display region 102 is disposed around the display region 101 is used for description, but the embodiments of the invention are not limited thereto, and the non-display region 102 may be disposed on one side, two sides, or three sides of the display region 101. In addition, when the display panel in the embodiments of the invention adopts full-screen display, the non-display region 102 may be folded or bent to the back of the display panel 1.

Specifically, the non-display region 102 may include a left border region, a right border region, an upper border region, and a lower border region that are respectively disposed on a left side, a right side, an upper side, and a lower side of the display region 101. Gate driving circuits may be disposed in the left border region and the right border region to input signals, and bonding terminals may be disposed in the lower border region to bond a driving chip.

Specifically, the functional region 103 may not perform display, and functional elements disposed in the functional region 103 include one or more of a camera, an ambient light detection element, a temperature detection element, a fingerprint recognition element, a touch element, an infrared sensing element, and a laser sensing element, to implement functions such as under-screen photographing, sensing, recognition, and detection.

Specifically, as shown in FIG. 1, the display region 101 may be disposed around the transition region 104, and the transition region 104 is disposed around the functional region 103, but the embodiments of the invention are not limited thereto. For example, the functional region 103 and the transition region 104 are disposed in a region where the display region 101 and the non-display region 102 are bordered, so that the display region 101 is not disposed around the transition region 104, but is disposed around a part of the transition region 104.

Specifically, as shown in FIG. 1, an example in which the shape of the functional region 103 is a circle and the shape of the transition region 104 is a ring is used for description in FIG. 1, but the embodiments of the invention are not limited thereto. The shape of the functional region 103 may be another shape, such as square, rectangle, or polygon. The shape of the functional region 103 may be designed as an ellipse, a water drop shape or other irregular figures. Correspondingly, the transition region 104 may be set to other shapes, which will not be elaborated here.

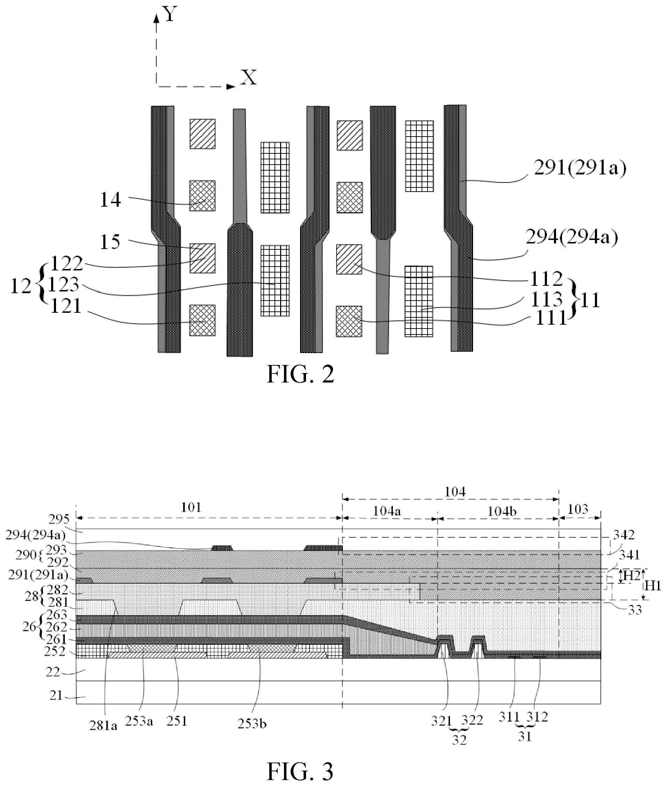

Specifically, as shown in FIG. 2, a plurality of non-anti-peeping pixels 11 and anti-peeping pixels 12 may be disposed in the display region 101. The non-anti-peeping pixels 11 may include one or more first non-anti-peeping sub-pixels 111, second non-anti-peeping sub-pixels 112, and third non-anti-peeping sub-pixels 113 of different emission colors, and the anti-peeping pixels 12 may include first anti-peeping sub-pixels 121, second anti-peeping sub-pixels 122, and third anti-peeping sub-pixels 123 of different emission colors.

Specifically, the emission color of one of the first non-anti-peeping sub-pixel 111, the second non-anti-peeping sub-pixel 112, and the third non-anti-peeping sub-pixel 113 is one of red, green, and blue, the emission color of another one of the first non-anti-peeping sub-pixel 111, the second non-anti-peeping sub-pixel 112, and the third non-anti-peeping sub-pixel 113 is another one of red, green, and blue, and the emission color of the remaining one of the first non-anti-peeping sub-pixel 111, the second non-anti-peeping sub-pixel 112, and the third non-anti-peeping sub-pixel 113 is the remaining one of red, green, and blue. For example, the emission colors of the first non-anti-peeping sub-pixel 111, the second non-anti-peeping sub-pixel 112, and the third non-anti-peeping sub-pixel 113 are red, green, or blue, respectively. Of course, the emission colors of the first non-anti-peeping sub-pixel 111, the second non-anti-peeping sub-pixel 112, and the third non-anti-peeping sub-pixel 113 can be other combinations, which will not be elaborated herein.

Specifically, the emission color of one of the first anti-peeping sub-pixel 121, the second anti-peeping sub-pixel 122, and the third anti-peeping sub-pixel 123 is one of red, green, and blue, the emission color of another one of the first anti-peeping sub-pixel 121, the second anti-peeping sub-pixel 122, and the third anti-peeping sub-pixel 123 is another one of red, green, and blue, and the emission color of the remaining one of the first anti-peeping sub-pixel 121, the second anti-peeping sub-pixel 122, and the third anti-peeping sub-pixel 123 is the remaining one of red, green, and blue. For example, the emission colors of the first anti-peeping sub-pixel 121, the second anti-peeping sub-pixel 122, and the third anti-peeping sub-pixel 123 are red, green, or blue, respectively. Of course, the emission colors of the first anti-peeping sub-pixel 121, the second anti-peeping sub-pixel 122, and the third anti-peeping sub-pixel 123 can be other combinations, which will not be elaborated herein.

Specifically, the emission colors of the first non-anti-peeping sub-pixel 111, the second non-anti-peeping sub-pixel 112, and the third non-anti-peeping sub-pixel 113 may be the same as those of the first anti-peeping sub-pixel 121, the second anti-peeping sub-pixel 122, and the third anti-peeping sub-pixel 123, respectively.

Specifically, to make the emission colors of the first non-anti-peeping sub-pixel 111, the second non-anti-peeping sub-pixel 112, and the third non-anti-peeping sub-pixel 113 different, the light-emitting portions of the respective non-anti-peeping sub-pixels are configured to have distinct emission colors. To make the emission colors of the first anti-peeping sub-pixel 121, the second anti-peeping sub-pixel 122, and the third anti-peeping sub-pixel 123 different, the light-emitting portions of the respective anti-peeping sub-pixels are configured to have distinct emission colors.

Specifically, for the arrangement of the sub-pixels in the non-anti-peeping pixel 11 and the anti-peeping pixel 12, the sub-pixels in the non-anti-peeping pixel 11 and the anti-peeping pixel 12 may adopt a real red-green-blue (real RGB) arrangement, an sub-pixel rendering (SPR) arrangement or other arrangements. The embodiments of the invention are not limited thereto. For example, the embodiments of the invention illustrate the case where the sub-pixels in both the non-anti-peeping pixel 11 and the anti-peeping pixel 12 adopt the real RGB arrangement.

Specifically, the embodiments of the invention do not limit the arrangement of non-anti-peeping pixels 11 and the anti-peeping pixels 12. For example, the non-anti-peeping pixels 11 and the anti-peeping pixels 12 are alternately arranged along the first direction X and the second direction Y. Alternatively, the non-anti-peeping pixels 11 are arranged in a plurality of columns, the anti-peeping pixels 12 are arranged in a plurality of columns, and the non-anti-peeping pixels and the anti-peeping pixels 12 are alternately arranged along the first direction X. In the embodiments of the invention, an example is given in which the non-anti-peeping pixels 11 and the anti-peeping pixels 12 are alternately arranged in both the first direction X and the second direction Y.

Specifically, the first non-anti-peeping sub-pixel 111 and the second non-anti-peeping sub-pixel 112 are arranged in the same column along the second direction Y, the first anti-peeping sub-pixel 121 and the second anti-peeping sub-pixel 122 are arranged in the same column along the second direction Y, and the third non-anti-peeping sub-pixel 113 and the third anti-peeping sub-pixel 123 are in separate columns.

Specifically, for the anti-peeping direction of the display panel in the embodiments of the invention, the embodiments of the invention are not limited. The display panel in the embodiments of the invention may implement omnidirectional anti-peeping, may implement three-way anti-peeping, or may implement bidirectional anti-peeping. For example, a first light-shielding portion 291a and a second light-shielding portion 294a are disposed around each of the first anti-peeping sub-pixel 121, the second anti-peeping sub-pixel 122, and the third anti-peeping sub-pixel 123, so that 360 degrees of omnidirectional anti-peeping may be implemented. Alternatively, the first light-shielding portion 291a and the second light-shielding portion 294a are arranged on both sides of each of the first anti-peeping sub-pixel 121, the second anti-peeping sub-pixel 122, and the third anti-peeping sub-pixel 123, so that bidirectional anti-peeping is implemented. In the following embodiments, the description is given by taking the case where the first light-shielding portion 291a and the second light-shielding portion 294a are arranged on both sides of each of the first anti-peeping sub-pixel 121, the second anti-peeping sub-pixel 122, and the third anti-peeping sub-pixel 123 as an example. When the anti-peeping direction of the display panel is other anti-peeping directions, adaptive design can be carried out accordingly.

In addition, when the display panel implements an anti-peeping mode, the first light-shielding portion 291a and the second light-shielding portion 294a may be arranged in different manners. For example, each of the first anti-peeping sub-pixels 121, the second anti-peeping sub-pixels 122, and the third anti-peeping sub-pixels 123 is surrounded by a first light-shielding portion 291a and a second light-shielding portion 294a, so that the second light-shielding portions 294a surrounding the first anti-peeping sub-pixel 121, the second anti-peeping sub-pixel 122, and the third anti-peeping sub-pixel 123 may be continuous, or the plurality of second light-shielding portions 294a surrounding the first anti-peeping sub-pixel 121, the second anti-peeping sub-pixel 122, and the third anti-peeping sub-pixel 123 may be disposed at intervals.

Specifically, the shape of the anti-peeping sub-pixels may be square, rectangular, rounded rectangular, circular, elliptical, or other shapes. Correspondingly, the side shapes of the first light-shielding portion 291a and the second light-shielding portion 294a that face the anti-peeping sub-pixels are adaptively adjusted. For example, if the anti-peeping sub-pixels are circular, the side shapes of the first light-shielding portion 291a and the second light-shielding portion 294a adjacent to the anti-peeping sub-pixels are arc-shaped, which will not be elaborated herein.

Specifically, the shape of the non-anti-peeping sub-pixel may be square, rectangular, rounded rectangular, circular, elliptical, or other shapes.

Specifically, as shown in FIG. 2, it can be seen that the anti-peeping pixels 12 and the non-anti-peeping pixels 11 are alternately arranged along the first direction X, and the anti-peeping pixels 12 and the non-anti-peeping pixels 11 are alternately arranged along the second direction Y. Both sides of each of the anti-peeping pixel 12 and the non-anti-peeping pixel 11 in the second direction Y are not provided with the first light-shielding portion 291a and the second light-shielding portion 294a. Each side in the first direction X of each of the first anti-peeping sub-pixel 121, the second anti-peeping sub-pixel 122, and the third anti-peeping sub-pixel 123 is provided with a first light-shielding portion 291a and a second light-shielding portion 294a, so as to limit light emission at a wide viewing angle of the anti-peeping sub-pixels and narrow the light emission angle of the anti-peeping pixel 12.

In the first direction X, a first light-shielding portion 291a is disposed between the first non-anti-peeping sub-pixel 111 and the third non-anti-peeping sub-pixel 113, a first light-shielding portion 291a is disposed between the second non-anti-peeping sub-pixel 112 and the third non-anti-peeping sub-pixel 113, no second light-shielding portion 294a is disposed between the first non-anti-peeping sub-pixel 111 and the third non-anti-peeping sub-pixel 113, and no second light-shielding portion 294a is disposed between the second non-anti-peeping sub-pixel 112 and the third non-anti-peeping sub-pixel 113; and a second light-shielding portion 294a is disposed between the anti-peeping pixel 12 and the non-anti-peeping pixel 11.

Specifically, as shown in FIG. 3 to FIG. 8B, the display panel 1 includes a substrate 21, a driving circuit layer 22, a light-emitting functional layer 25, and an encapsulation layer 26. The driving circuit layer 22 is disposed on a side of the substrate 21, the light-emitting functional layer 25 is disposed on a side of the driving circuit layer 22 away from the substrate 21, and the encapsulation layer 26 is disposed on a side of the light-emitting functional layer 25 away from the driving circuit layer 22.

Specifically, as shown in FIG. 3 to FIG. 8B, the display panel 1 may further include a touch layer 27, and the touch layer 27 is disposed on a side of the encapsulation layer 26 away from the light-emitting functional layer 25.

Specifically, as shown in FIG. 3 to FIG. 8B, the display panel 1 further includes a dimming functional layer 28, and the dimming functional layer 28 is disposed on a side of the touch layer 27 away from the encapsulation layer 26.

Specifically, the dimming functional layer 28 includes a first refractive index layer 281 and a second refractive index layer 282, and a refractive index of the second refractive index layer 282 is greater than a refractive index of the first refractive index layer 281.

Specifically, the first refractive index layer 281 may include photoresist, and in this case, the first refractive index layer 281 may be formed by completely coating the photoresist and then exposing and developing the photoresist.

Specifically, the first refractive index layer 281 may include poly(methyl methacrylate) (PMMA), polyacrylic acid, ethylhexyl acrylate, pentafluoropropyl acrylate, or an acrylic resin such as polyethylene glycol dimethacrylate or ethylene glycol dimethacrylate. In some embodiments, the first refractive index layer 281 may further include a thermal a curing agent such as an epoxy resin, and/or a photo-curing agent.

Specifically, the second refractive index layer 282 may include an acrylic organic material or a siloxane-based organic material. In some embodiments, the second refractive index layer 282 may include polydiarylsiloxane, methyltrimethoxysilane, or tetramethoxysilane. In some embodiments, the second refractive index layer 282 may be formed by applying an organic material via an inkjet printing process and curing the organic material. In another embodiment, the second refractive index layer 282 may be formed by an evaporation process.

In some embodiments, metal oxide particles such as ZnO, TiO₂, zirconium dioxide (ZrO₂), and barium titanate (BaTiO₃) may be dispersed in the second refractive index layer 282. In some embodiments, the second refractive index layer 282 may be formed by applying an organic material doped with metal oxide particles via an inkjet printing process. Therefore, the refractive index of the second refractive index layer 282 may be greater than the refractive index of the first refractive index layer 281.

Specifically, the refractive index of the first refractive index layer 281 ranges from 1.45 to 1.55, and the distance between the opening of the first refractive index layer 281 and the opening of the pixel definition layer on the same side ranges from 0 to 1.5 micrometers, that is, in the first direction and/or the second direction, on one or more sides of the left side, the right side, the upper side, and the lower side, the boundary of the opening of the first refractive index layer 281 extends beyond the boundary of the opening of the pixel definition layer by at most 1.5 micrometers, or the boundary of the opening of the first refractive index layer 281 is located in the opening of the pixel definition layer, and the boundary of the opening of the first refractive index layer 281 is inwardly retracted by a maximum of 1.5 micrometers relative to the boundary of the opening of the pixel definition layer.

Specifically, the thickness of the first refractive index layer 281 ranges from 1.5 micrometers to 3.5 micrometers.

Specifically, the refractive index of the second refractive index layer 282 ranges from 1.6 to 1.8; and the thickness of the second refractive index layer 282 ranges from 2.5 micrometers to 5 micrometers.

Specifically, as shown in FIG. 3 to FIG. 8B, the display panel 1 further includes a first light-shielding layer 291, a first planarization layer 290, a second light-shielding layer 294, and a second planarization layer 295 that are sequentially disposed.

Specifically, the thickness of the first light-shielding layer 291 ranges from 0.9 micrometers to 1.2 micrometers. In the non-anti-peeping pixel 11, the distance between the boundary of the first light-shielding portion 291a and the boundary of the opening of the pixel definition layer ranges from 3 micrometers to 5 micrometers, and in the anti-peeping pixel 12, the distance between the boundary of the first light-shielding portion 291a and the opening of the pixel definition layer ranges from 1 micrometers to 1.5 micrometers.

Specifically, the material of the first light-shielding layer 291 may include a light absorbing material. For example, the first light-shielding layer 291 may include an inorganic black pigment or an organic black pigment. The inorganic black pigment may be carbon black, and the organic black pigment may include at least one of lactam black, perylene black, and aniline black, but the embodiments of the invention are not limited thereto.

Specifically, the material of the first planarization layer 290 may include an organic material such as acrylic acid, benzocyclobutene (BCB), or hexamethyldisiloxane (HMDSO).

Specifically, as shown in FIG. 3 to FIG. 8B, the first planarization layer 290 may include a first sub-layer 292 and a second sub-layer 293. The material of the first sub-layer 292 may include an organic material such as acrylic, benzocyclobutene, or hexamethyldisiloxane. The material of the second sub-layer 293 may include an organic material such as acrylic, benzocyclobutene, or hexamethyldisiloxane.

Specifically, the thickness of the first planarization layer 290 ranges from 7 micrometers to 9 micrometers; the thickness of the first sub-layer 292 ranges from 4 micrometers to 5 micrometers; and the thickness of the second sub-layer 293 ranges from 3 micrometers to 4 micrometers.

Specifically, the second light-shielding layer 294 includes a plurality of second light-shielding portions 294a located on both sides of each of the anti-peeping sub-pixels, and the width of the second light-shielding portion 294a ranges from 6 to 8 micrometers.

Specifically, the material of the second light-shielding layer 294 may include a light absorbing material. For example, the second light-shielding layer 294 may include an inorganic black pigment or an organic black pigment. The inorganic black pigment may be carbon black, and the organic black pigment may include at least one of lactam black, perylene black, and aniline black, but the embodiments of the invention are not limited thereto.

Specifically, the materials of the first light-shielding layer 291 and the second light-shielding layer 294 may be black photoresist, that is, the first light-shielding layer 291 and the second light-shielding layer 294 may be black matrix layers.

Specifically, the thickness of the second planarization layer 295 ranges from 3 micrometers to 5 micrometers.

Specifically, the material of the second planarization layer 295 may include an organic material such as acrylic acid, benzocyclobutene (BCB), or hexamethyldisiloxane (HMDSO).

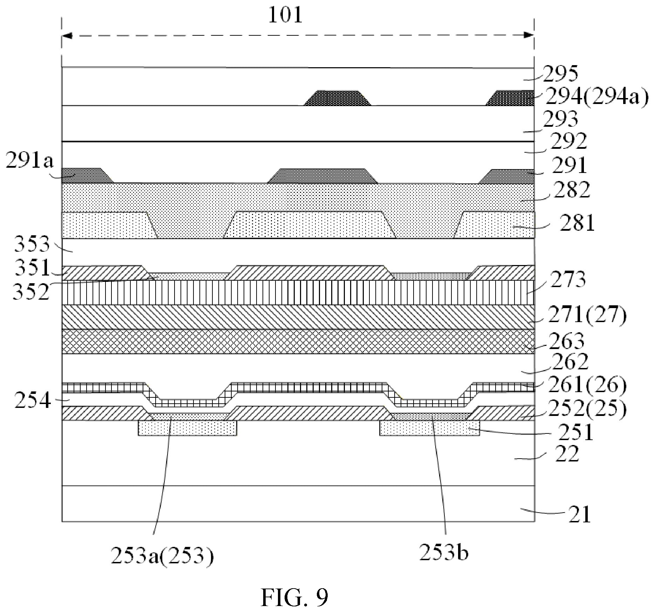

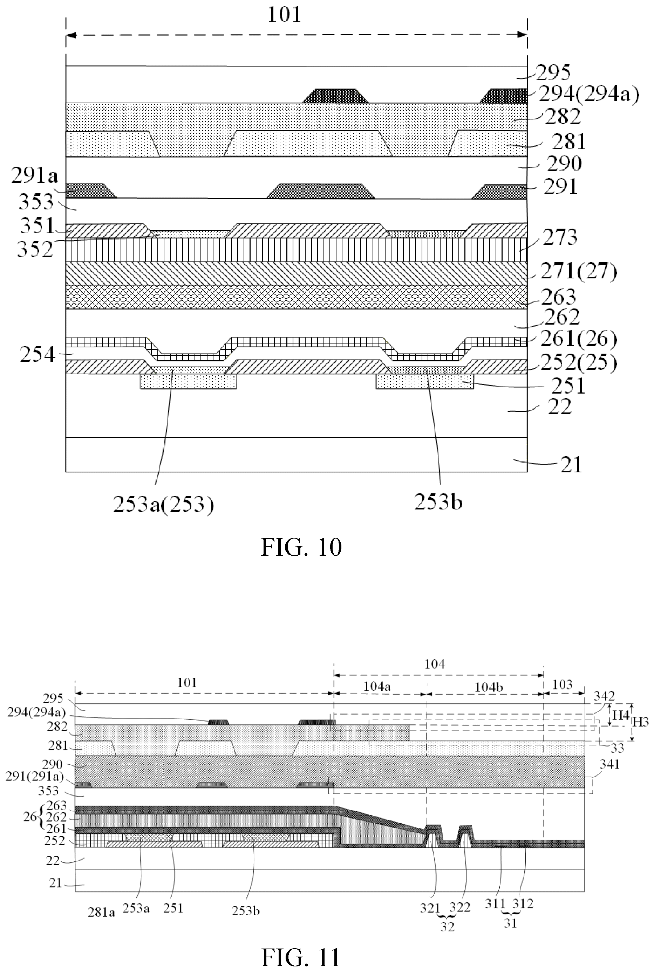

Specifically, as shown in FIG. 9 and FIG. 10, the display panel 1 may further include a third light-shielding layer 351 and a color resist layer 352, and the third light-shielding layer 351 and the color resist layer 352 may be disposed between the light-emitting functional layer 25 and the dimming functional layer 28.

Specifically, as shown in FIG. 9 and FIG. 10, the display panel 1 may further include a third planarization layer 353, and the third planarization layer 353 is disposed between the third light-shielding layer 351 and the dimming functional layer 28.

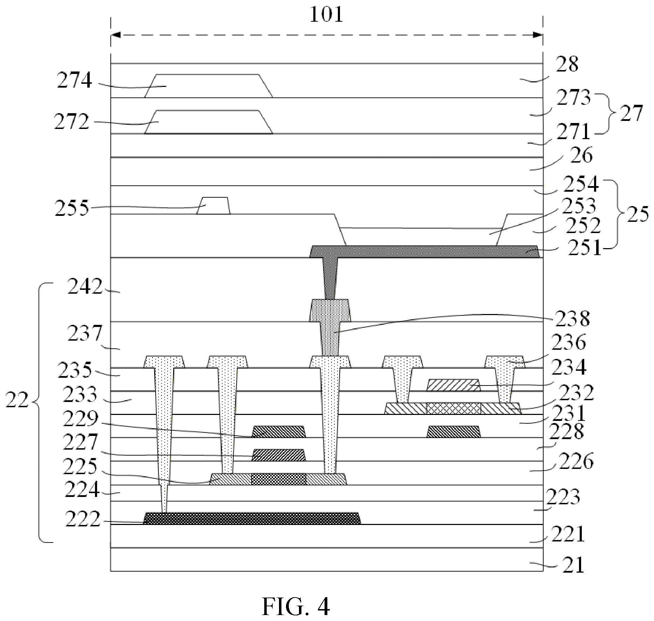

Specifically, as shown in FIG. 4, the driving circuit layer 22 includes a first barrier layer 221, a light-shielding metal layer 222, a second barrier layer 223, a buffer layer 224, an active layer 225, a first gate insulating layer 226, a first gate layer 227, a second gate insulating layer 228, a second gate layer 229, a first interlayer insulating layer 231, a semiconductor layer 232, a third gate insulating layer 233, a third gate layer 234, a second interlayer insulating layer 235, a first source-drain layer 236, a first flattening layer 237, a second source-drain layer 238, and a second flattening layer 242.

Specifically, the material of the active layer may be a silicon semiconductor, and the material of the semiconductor layer may be an oxide semiconductor.

Specifically, in the driving circuit layer 22 shown in FIG. 4, an example in which one active layer and one semiconductor layer, three gate layers and two source-drain layers are sequentially disposed is used for description, but the embodiments of the invention are not limited thereto. For example, the driving circuit layer 22 may be provided with one gate layer or two gate layers, when there are two gate layers, the two gate layers are disposed on both sides of the active layer respectively, or on the same side of the active layer, one gate layer forms a gate, and another gate layer forms a capacitor and/or a signal line. Alternatively, the driving circuit layer 22 includes one active layer, and the driving circuit layer 22 may be provided with one or three source-drain layers. The film layer structure of the driving circuit layer 22 in the embodiments of the invention is only an example, and the structure of the driving circuit layer 22 in the embodiments of the invention may be other structures, which will not be elaborated here.

Specifically, as shown in FIG. 4, the light-emitting functional layer 25 includes a pixel electrode layer 251, a pixel definition layer 252, a light-emitting material layer 253, and a common electrode layer 254.

Specifically, the pixel definition layer 252 may include only one film layer, and a single film layer may be made of a transparent material or include a light-shielding material. Alternatively, the pixel definition layer 252 may include two film layers, for example, the pixel definition layer 252 may include a first pixel definition layer and a second pixel definition layer, a light transmittance of the first pixel definition layer is greater than a light transmittance of the second pixel definition layer, and both the first pixel definition layer and the second pixel definition layer are formed by a light-transmitting photoresist, except that the second pixel definition layer is doped with the light-shielding material. The hydrophilicity of the first pixel definition layer may be greater than the hydrophilicity of the second pixel definition layer. The arrangement positions of the first pixel definition layer and the second pixel definition layer may be set according to requirements.

Specifically, when the material of the pixel definition layer 252 includes the light-shielding material, the third light-shielding layer and the color resist layer are used; and when the material of the pixel definition layer 252 is the transparent material, the polarizer is used to reduce the reflection.

Specifically, as shown in FIG. 4, the light-emitting functional layer 25 further includes a spacer 255.

Specifically, as shown in FIG. 3 to FIG. 8B, the encapsulation layer 26 includes a first inorganic encapsulation layer 261, an organic encapsulation layer 262, and a second inorganic encapsulation layer 263.

Specifically, the first inorganic encapsulation layer may include at least one inorganic material of Al₂O₃, TiO₂, Ta₂O₅, HfO₂, ZnO, SiO₂, SiN_{X}, and SiON.

In some embodiments, the first inorganic encapsulation layer 261 may include SiON. The second inorganic encapsulation layer 263 may include SiN_{X}.

Specifically, the organic encapsulation layer 262 may include a polymer material. The polymer material may include acrylic resin, epoxy resin, polyimide, polyethylene, and the like. In some embodiments, the organic encapsulation layer may include an acrylate.

Specifically, the thickness of the first inorganic encapsulation layer 261 ranges from 1 micrometer to 1.5 micrometers; the thickness of the organic encapsulation layer 262 ranges from 9 micrometers to 11 micrometers, and the thickness of the second inorganic encapsulation layer 263 ranges from 0.6 micrometers to 0.8 micrometers.

Specifically, as shown in FIG. 4, the touch layer 27 includes a first touch insulating layer 271, a first touch metal layer 272, a second touch insulating layer 273, and a second touch metal layer 274, but the embodiments of the invention are not limited thereto. The number of the touch metal layers and the touch insulating layers may be other numbers, and the film order of the touch metal layers and the touch insulating layers may be other orders, for example, the touch layer 27 may further include a third touch insulating layer disposed on the second touch metal layer 274.

Specifically, the materials of the first touch insulating layer 271, the second touch insulating layer 273, and the third touch insulating layer may be silicon nitride; and the thicknesses of the first touch insulating layer 271, the second touch insulating layer 273, and the third touch insulating layer range from 0.1 micrometers to 0.3 micrometers.

Specifically, the pixel definition layer 252 includes a plurality of openings respectively corresponding to the first non-anti-peeping sub-pixel 111, the second non-anti-peeping sub-pixel 112, and the third non-anti-peeping sub-pixel 113, and the areas of the openings may be the same or different.

Specifically, the pixel definition layer 252 includes a plurality of openings respectively corresponding to the first anti-peeping sub-pixel 121, the second anti-peeping sub-pixel 122, and the third anti-peeping sub-pixel 123, and the areas of the openings may be the same or different. The widths of the openings may be made similar, so as to ensure that just noticeable color difference (JNCD, which is used to characterize chromatic aberration) of the anti-peeping pixels at different viewing angles is similar or even the same.

Specifically, the area of the opening corresponding to the first non-anti-peeping sub-pixel 111 in the pixel definition layer 252 may be equal to the area of the opening corresponding to the first anti-peeping sub-pixel 121 in the pixel definition layer 252. The area of the opening corresponding to the second non-anti-peeping sub-pixel 112 in the pixel definition layer 252 may be equal to the area of the opening corresponding to the second anti-peeping sub-pixel 122 in the pixel definition layer 252. The area of the opening corresponding to the third non-anti-peeping sub-pixel 113 in the pixel definition layer 252 may be equal to the area of the opening corresponding to the third anti-peeping sub-pixel 123 in the pixel definition layer 252.

In some embodiments, when the display panel 1 is configured in the sharing mode, both the non-anti-peeping pixel 11 and the anti-peeping pixel 12 emit light; when the display panel 1 is configured in the anti-peeping mode, the non-anti-peeping pixel 11 does not emit light, and the anti-peeping pixel 12 emits light.

In some embodiments, when the viewing angle is 30 degrees to 45 degrees, the brightness of the anti-peeping pixel 12 is 1% to 10% of the brightness of the front viewing angle (which may be regarded as 0 degrees); when the viewing angle is 60 degrees, the brightness of the non-anti-peeping pixel 11 is 20% to 30% of the brightness of the front viewing angle.

Specifically, since the pixel is specifically formed by the light-emitting functional layer, the first light-shielding layer 291, the second light-shielding layer 294, and the light-emitting functional layer 25 are different film layers and are located on different planes in the thickness direction of the display panel. Therefore, when describing the positional relationship between the first light-shielding layer 291, the second light-shielding layer 294, and the pixel or the light-emitting portion of the pixel in the first direction X and the second direction Y, the first light-shielding layer 291, the second light-shielding layer 294 and the light-emitting functional layer 25 need to be arranged on the same plane, and therefore, the relative positions of the structures of the film layers can be described based on the projections of the first light-shielding layer 291, the second light-shielding layer 294, and the light-emitting functional layer 25 on the same plane.

It may be understood that the plane may be a plane on which the substrate is located, may be a ground, or may be other film layers or another interfaces.

Specifically, in the projection on the same plane, in the first direction X, both sides of the anti-peeping pixel are each provided with the first light-shielding portion 291a and the second light-shielding portion 294a for specific description: that is, in the first direction X, both sides of the projection of the light-emitting portion of the anti-peeping pixel on a plane are each provided with the projections of a first light-shielding portion 291a and a second light-shielding portion 294a on the same plane. Similarly, meanings of other relative positions may be determined, and details are not described herein again.

Specifically, in the following embodiments, when different structures are located in different film layers, the relative positions of the plurality of structures in the first direction X and the second direction Y are described based on their projections on the same plane, which will not be elaborated in the following embodiments.

In some embodiments, the display panel 1 further includes a bonding region 102a, and the bonding region 102a is disposed on a side of the display panel 1 along the second direction Y, so that the non-anti-peeping pixel 11 is not provided with the first light-shielding portion 291a and the second light-shielding portion 294a on the upper and lower sides, thereby slowing down the brightness attenuation on the upper and lower sides of the display panel, improving the transmittance of the display panel, and improving the field of view performance of the display panel.

As shown in FIG. 1 to FIG. 10, embodiments of the invention provide a display panel, the display panel includes a display region 101, a functional region 103, and a transition region 104. The transition region 104 is disposed between the display region 101 and the functional region 103. The display panel 1 includes a substrate 21 and a dimming functional layer 28, a first light-shielding layer 291, a first planarization layer 290, a second light-shielding layer 294, and a second planarization layer 295 that are disposed on a side of the substrate 21. The dimming functional layer 28 includes a first refractive index layer 281 and a second refractive index layer 282, the first refractive index layer 281 is disposed between the substrate 21 and the second refractive index layer 282, and a refractive index of the first refractive index layer 281 is less than a refractive index of the second refractive index layer 282.

At least one of the second refractive index layer 282, the first planarization layer 290, and the second planarization layer 295 is provided with a first through hole 33, the first through hole 33 is disposed in the functional region 103 and the transition region 104, and a boundary of the first through hole 33 is located in the transition region 104.

Embodiments of the invention provide a display panel. In the display panel 1, at least one of the second refractive index layer 282, the first planarization layer 290, and the second planarization layer 295 is provided with the first through hole 33, the first through hole 33 is disposed in the functional region 103 and the transition region 104, and the boundary of the first through hole 33 is located in the transition region, so that the internal stress between adjacent film layers can be reduced, the internal stress conducted to the lower film layer can be reduced, the stress on the lower film layer can be reduced, and the risk of peeling off the light-emitting material layer and the common electrode layer can be reduced, thereby reducing the risk of water and oxygen intrusion, improving the encapsulation effect, and improving reliability of the display panel.

Specifically, in some display devices, in order to achieve the anti-peeping effect, a plurality of black matrix layers are provided to shield the light emitted from the sub-pixels at a wide viewing angle, but this design needs to add a plurality of organic layers and shielding layers, and in order to improve the efficiency reduction problem caused by the anti-peeping design, a solution for improving the light-emitting efficiency will be used, such as a micro lens panel (MLP) technology. Since the MLP technology needs to use materials with different refractive indexes, different materials have a shrinkage rate difference in a high-temperature and high-humidity environment, which is easy to generate interface stress and then lead to film layer peeling, especially film layer peeling in the hole region and lead to encapsulation failure.

In view of this technical problem, in the embodiments of the invention, at least one of the second refractive index layer 282, the first planarization layer 290, and the second planarization layer 295 is provided with the first through hole 33, and the boundary of the first through hole 33 is located in the transition region, so that the overlapping area of two adjacent layers is reduced, and the internal stress between adjacent film layers is reduced. In this way, the internal stress conducted to the underlying inorganic layer is reduced, the stress on the underlying inorganic layer and the light-emitting layer is reduced, which can reduce the risk of peeling off the light-emitting material layer and the common electrode layer, reduce the risk of water and oxygen intrusion, improve the encapsulation effect, and improve the reliability of the display panel.

Specifically, some principles of generating the stress on the inorganic layer and the light-emitting layer by different film layers are described as follows: in the high-temperature and high-humidity environment, the film layers will shrink, and due to the different materials of different film layers, the shrinkage rate of different film layers is different, then the deformation between different film layers is different, resulting in the deformation of the film layers to stress the inorganic layer and the light-emitting layer on the lower side, thereby causing the light-emitting layer to peel off.

For example, the shrinkage rate of the second refractive index layer 282 is different from that of the first refractive index layer 281 in a high-temperature and high-humidity environment, for example, the shrinkage rate of the second refractive index layer 282 is relatively high, which will generate tensile stress on the inorganic encapsulation layer, the light-emitting material layer, and the common electrode layer, resulting in peeling of the light-emitting layer. Alternatively, the shrinkage rate of the first refractive index layer 281 is relatively high, and the first refractive index layer 281 will generate compressive stress on the inorganic encapsulation layer, the light-emitting material layer, and the common electrode layer, resulting in peeling of the light-emitting layer. Certainly, when film peeling is caused by other principles, the solutions in the embodiments of the invention may also be used to resolve this technical problem.

In some embodiments, as shown in FIG. 3 to FIG. 8B, the display panel 1 further includes an isolation column 31. The isolation column 31 includes an undercut structure 3a, the isolation column 31 is disposed in the transition region 104, and a boundary of the first through hole is located between the isolation column 31 and the display region 101, so that stress concentration points can be avoided, the risk of peeling of the light-emitting layer can be reduced, and the reliability of the display panel can be improved.

Specifically, in the display panel 1, in order to prevent water and oxygen intrusion from causing encapsulation failure, the isolation column 31 is disposed in the transition region 104 to isolate some common layers in the light-emitting functional layer 25. For example, the light-emitting material layer includes a hole layer, an electron layer, and an emission layer, the hole layer and the electron layer may be continuously disposed across a plurality of sub-pixels, the emission layer is disposed corresponding to each sub-pixel, and the emission layers corresponding to the plurality of sub-pixels may be disconnected, then the hole layer and the electron layer may be common layers, so that the isolation column 31 isolates the hole layer and the electron layer, thereby avoiding water and oxygen intrusion.

However, the problem of stress concentration easily occurs in the region where the isolation column 31 is located, resulting in the problem of warping of the common layers separated by the isolation column 31, which in turn leads to the intrusion of water and oxygen from the interior of the common layer and the interface between the common layer and other film layers, resulting in the intrusion of water and oxygen into the display region. In addition, the peeling of the film layers will affect the connection effect of other film layers, further increasing the risk of encapsulation failure. In the embodiments of the invention, the boundary of the first through hole 33 is located between the isolation column 31 and the display region 101, so that the stress concentration point can be avoided, and the stress applied to the position of the isolation column 31 is small, the risk of film peeling is reduced, the encapsulation effect is improved, and the reliability of the display panel is improved.

Specifically, in the region where the isolation column 31 is located, due to the relatively complex structure, the film layer itself will have internal stress, and when the upper film layer generates stress on the inorganic layer and the light-emitting layer in the region where the isolation column 31 is located, the risk of peeling off the inorganic layer and the light-emitting layer will be further increased. In the embodiments of the invention, the first through hole is arranged in some film layers in the region corresponding to the isolation column 31, so as to prevent the shrinkage of the film layers in such region from generating stress on the inorganic layers and the light-emitting layers, and reduce the risk of peeling of the inorganic layers and the light-emitting layer.

Specifically, the light-emitting material layer includes a hole layer, an electron layer, and an emission layer. The hole layer may include a hole injection layer and a hole transport layer, and the electron layer may include an electron transport layer and an electron injection layer.

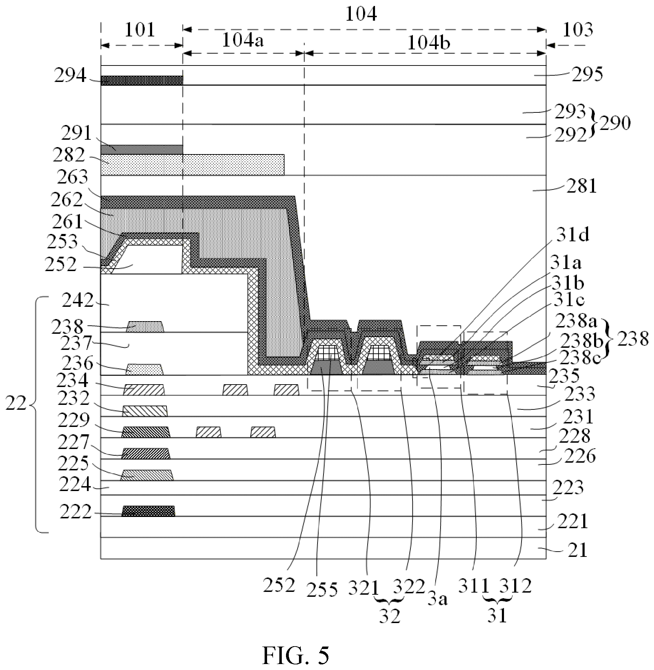

In some embodiments, the common layer further includes a common electrode layer 254, and in FIG. 5, the light-emitting material layer 253 is disconnected at the isolation column 31 for illustration. Similarly, the common electrode layer 254 may be disconnected at the isolation column 31.

In some embodiments, the light-emitting material layer is disconnected by the isolation column 31, and the common electrode layer 254 is disconnected by the isolation column 31.

In some embodiments, as shown in FIG. 5, the display panel 1 further includes a light-emitting material layer 253, and the light-emitting material layer 253 is disposed between the substrate 21 and the dimming functional layer 28. The isolation column 31 includes a first isolation portion 31a and a second isolation portion 31b. The second isolation portion 31b is disposed between the first isolation portion 31a and the substrate 21. The first isolation portion 31a extends beyond the second isolation portion 31b to form an isolation groove 31d, and the light-emitting material layer 253 is disconnected at the isolation groove 31d. In this way, the light-emitting material layer 253 can be disconnected by the isolation column 31, the intrusion of water and oxygen from the light-emitting material layer 253 into the display region is avoided, and the encapsulation effect is improved.

Specifically, the first isolation portion 31a and the second isolation portion 31b in the isolation column 31 may be formed by some film layers of the driving circuit layer or may be formed by independent film layers. For example, the first isolation portion 31a and the second isolation portion 31b in the isolation column 31 may be formed by a second source-drain layer of the driving circuit layer, or formed by combining an insulating layer and a metal layer of the driving circuit layer, or formed by one or more insulating layers of the driving circuit layer, which is not limited in the embodiments of the invention.

Specifically, the isolation column 31 may further include a third isolation portion 31c, and the third isolation portion 31c is disposed between the second isolation portion 31b and the substrate 21. The third isolation portion 31c extends beyond the second isolation portion 31b, and portions of the first isolation portion 31a and the third isolation portion 31c extending beyond the second isolation portion 31b form the isolation groove 31d together with the second isolation portion 31b.

Specifically, as shown in FIG. 5, the width of the second isolation portion 31b is smaller than the width of the first isolation portion 31a, and the width of the second isolation portion 31b is smaller than the width of the third isolation portion 31c. Both sides of the second isolation portion 31b are each provided with the isolation groove, the light-emitting material layer is disconnected by the isolation grooves, and the common electrode layer is disconnected by the isolation grooves, so that the common layer can be disconnected by the isolation columns 31 to realize the encapsulation of the display panel.

Specifically, the undercut structure 3a may be composed of the first isolation portion 31a, the second isolation portion 31b, and the isolation groove 31d, or may be composed of the first isolation portion 31a, the second isolation portion 31b, the third isolation portion 31c, and the isolation groove 31d.

Specifically, as shown in FIG. 5, the isolation column 31 may be disposed in the second source-drain layer 238, thereby avoiding adding processes and film layers of the display panel, improving the manufacturing efficiency of the display panel, and reducing the thickness of the display panel.

Specifically, as shown in FIG. 5, the second source-drain layer 238 includes a first titanium layer 238a, an aluminum layer 238b, and a second titanium layer 238c. The material of the first titanium layer 238a and the material of the second titanium layer 238c are titanium, and the material of the aluminum layer 238b is aluminum. The first isolation portion 31a, the second isolation portion 31b, and the third isolation portion 31c may be respectively disposed in the first titanium layer 238a, the aluminum layer 238b, and the second titanium layer 238c, so that the isolation groove can be formed through different etching properties of materials, thereby disconnecting the common layer.

Specifically, the above embodiments are described by taking the second source-drain layer 238 forming the isolation column 31 as an example, but the embodiments of the invention are not limited thereto, and the isolation column 31 may be formed by other film layers. For example, the isolation column 31 may be formed by the first source-drain layer, and when the driving circuit layer of the display panel is of other film layers, the isolation column 31 may be formed by other film layers, for example, the driving circuit layer includes a third source-drain layer, and the isolation column 31 may be formed by the third source-drain layer.

In some embodiments, in order to improve the isolation effect of the isolation column 31, the isolation column may be formed by a plurality of metal layers and insulating layers between the plurality of metal layers, for example, the isolation column 31 is formed by the third gate layer 234, the second interlayer insulating layer 235, and the second source-drain layer 238. The third gate layer 234 and the second interlayer insulating layer 235 raise the second source-drain layer 238, and a plurality of film layers of the second source-drain layer 238 form the isolation groove, thereby disconnecting the common layer.

Specifically, in the embodiments of the invention, an example in which the second source-drain layer 238 includes the first titanium layer 238a, the aluminum layer 238b, and the second titanium layer 238c is used for description, but the embodiments of the invention are not limited thereto, and the second source-drain layer 238 may be another film layer.

Specifically, the isolation column may be formed by an independent film layer, and the isolation column may be formed by two film layers to form the isolation groove, which will not be elaborated in the embodiments of the invention.

In some embodiments, as shown in FIG. 3 and FIG. 5 to FIG. 8B, the isolation column 31 includes a first isolation column 311 and a second isolation column 312, and the first isolation column 311 is disposed between the second isolation column 312 and the display region 101. In this way, the isolation effect is improved, the risk of water and oxygen invading from the common layer is reduced, and the encapsulation performance of the display panel is improved.

Specifically, when the isolation column is provided, in order to avoid the encapsulation failure caused by the failure of a single isolation column 31 to partition the common layer, a plurality of isolation columns arranged at intervals may be provided, for example, the first isolation column 311 and the second isolation column 312 arranged at intervals are provided, so that the common layer can be disconnected by the first isolation column 311 and the second isolation column 312, thereby reducing the risk of water and oxygen invading from the common layer and improving the encapsulation performance of the display panel.

In some embodiments, as shown in FIG. 3 and FIG. 5 to FIG. 8B, the isolation column 31 includes a first isolation column 311 and a second isolation column 312, and the first isolation column 311 is disposed between the second isolation column 312 and the display region 101. The boundary of the first through hole 33 is located between the first isolation column 311 and the display region 101, so that stress concentration points can be avoided, the risk of peeling off the light-emitting layer can be reduced, and the reliability of the display panel can be improved.

Specifically, when the isolation column 31 includes the first isolation column 311 and the second isolation column 312, stress concentration is prone to occur in the region where the first isolation column 311 and the second isolation column 312 are located, resulting in warping of the common layer separated by the first isolation column 311 and the second isolation column 312, which in turn leads to intrusion of water and oxygen from the interior of the common layer and the interface between the common layer and other film layers, resulting in intrusion of water and oxygen into the display region. In addition, film peeling may affect the connection effect of other film layers, thereby further improving the risk of encapsulation failure. In the embodiments of the invention, the boundary of the first through hole 33 is located between the first isolation column 311 and the display region 101, so that the stress concentration point can be avoided, and the stress applied to the position of the first isolation column 311 is small, the risk of film peeling is reduced, the encapsulation effect is improved, and the reliability of the display panel is improved.

Specifically, the boundary of the first through hole 33 may be located between the second isolation column 312 and the display region 101. The boundary of the first through hole 33 may be located between the second isolation column 312 and the first isolation column 311, or the boundary of the first through hole 33 may be located above the first isolation column 311.

In some embodiments, the display panel 1 further includes a retaining wall 32 disposed in the transition region 104, the retaining wall 32 is located between the isolation column 31 and the display region 101, and the boundary of the first through hole 33 is located between the retaining wall 32 and the display region 101, so that stress concentration points can be avoided, the risk of peeling of the light-emitting layer can be reduced, and the reliability of the display panel can be improved.

Specifically, in the display panel 1, to prevent the encapsulation failure caused by the intrusion of water and oxygen, the retaining wall 32 is disposed in the transition region 104 to block the organic encapsulation layer, so as to avoid the intrusion of water and oxygen from the organic encapsulation layer and/or the interface between the organic encapsulation layer and the inorganic encapsulation layer caused by the overflow of the organic encapsulation layer to the functional region. However, stress concentration is prone to occur in the region where the retaining wall 32 is disposed, resulting in warping of the common layer and/or other film layers, which in turn leads to intrusion of water and oxygen from the interior of the common layer and the interface between the common layer and other film layers, or intrusion of other warped film layers. This further results in intrusion of water and oxygen into the display region, and peeling of the film layers will affect the connection effect of other film layers, thereby further increasing the risk of encapsulation failure. In the embodiments of the invention, the boundary of the first through hole 33 is located between the retaining wall 32 and the display region 101, so that the stress concentration point can be avoided, the stress applied to the positions of the retaining wall 32 and the isolation column is small, the risk of film peeling is reduced, the encapsulation effect is improved, and the reliability of the display panel is improved.

Specifically, in the region where the retaining wall 32 is located, due to the relatively complex structure, the film layer itself will have internal stress, and when the upper film layer generates stress on the inorganic layer and the light-emitting layer in the region where the retaining wall 32 is located, the risk of peeling off the inorganic layer and the light-emitting layer will be further increased. In the embodiments of the invention, the first through hole is arranged in some film layers in the region corresponding to the retaining wall 32, so as to prevent the shrinkage of the film layers in such region from generating stress on the inorganic layers and the light-emitting layers, and reduce the risk of peeling of the inorganic layers and the light-emitting layer.

It can be understood that since the inorganic layer and the light-emitting layer where the retaining wall 32 and the isolation column 31 are located are closer to the upper film layer than other regions, the stress generated by the upper film layer on the inorganic layer and the light-emitting layer will be greater, which will increase the risk of peeling off the inorganic layer and the light-emitting layer. In the embodiments of the invention, the first through hole is provided in some film layers in the region corresponding to the retaining wall 32, so as to prevent the shrinkage of the film layers in this region from generating stress on the inorganic layers and the light-emitting layers, and reduce the risk of peeling of the inorganic layers and the light-emitting layers.

In some embodiments, the retaining wall 32 includes portions of the pixel definition layer 252 and the spacer 255, thereby avoiding increasing the process and film layers of the display panel, improving the manufacturing efficiency of the display panel, and reducing the thickness of the display panel.

In some embodiments, the retaining wall 32 may further include a portion of the second planarization layer 242. In some embodiments, the retaining wall 32 may further include a portion of the first planarization layer 237.

In some embodiments, as shown in FIG. 3 and FIG. 5 to FIG. 8B, the retaining wall 32 includes a first retaining wall 321 and a second retaining wall 322, and the first retaining wall 321 is disposed between the second retaining wall 322 and the display region 101.

Specifically, when the retaining wall is provided, to avoid encapsulation failure caused by the single retaining wall not blocking the organic encapsulation layer, a plurality of retaining walls may be provided at intervals, for example, the first retaining wall 321 and the second retaining wall 322 are provided at intervals, so that the organic encapsulation layer overflowing from the first retaining wall 321 can also be blocked by the second retaining wall 322, thereby reducing the risk of water and oxygen intrusion and improving the encapsulation performance of the display panel.

In some embodiments, as shown in FIG. 3, FIG. 5 to FIG. 8B, the retaining wall 32 includes a first retaining wall 321 and a second retaining wall 322, the first retaining wall 321 is disposed between the second retaining wall 322 and the display region 101, and the boundary of the first through hole 33 is located between the first retaining wall 321 and the display region 101, so that stress concentration points can be avoided, the risk of peeling off the light-emitting layer can be reduced, and the reliability of the display panel can be improved.

Specifically, when the retaining wall 32 includes the first retaining wall 321 and the second retaining wall 322, the region where the first retaining wall 321 and the second retaining wall 322 are located is prone to stress concentration, resulting in the problem of warping of the common layer separated by the isolation column, which in turn leads to the intrusion of water and oxygen from the interior of the common layer and the interface between the common layer and other film layers, resulting in the intrusion of water and oxygen into the display region. In addition, the peeling of the film layers will affect the connection effect of other film layers, further improving the risk of encapsulation failure. In the embodiments of the invention, the boundary of the first through hole 33 is located between the first retaining wall 321 and the display region 101, so that the stress concentration point can be avoided, the stress applied to the positions of the first retaining wall 321, the second retaining wall 322, and the isolation column is small, the risk of film peeling is reduced, the encapsulation effect is improved, and the reliability of the display panel is improved.

Specifically, the boundary of the first through hole 33 may be located on the side of the second retaining wall 322 close to the display region, or the boundary of the first through hole 33 may be located between the isolation column and the second retaining wall 322, for example, the boundary of the first through hole 33 may be between the first isolation column 311 and the second retaining wall 322. The boundary of the first through hole 33 may be located between the second retaining wall 322 and the display region 101. The boundary of the first through hole 33 may be located between the second retaining wall 322 and the first retaining wall 321. The boundary of the first through hole 33 may be located above the first retaining wall 321. The boundary of the first through hole 33 may be located above the second retaining wall 322.

Specifically, it can be understood that when the boundary of the first through hole 33 is disposed between the first retaining wall 321 and the display region 101, stress concentration points such as the retaining wall and the isolation column can be avoided, thereby reducing the internal stress and improving the reliability of the display panel.

In some embodiments, as shown in FIG. 3, the transition region 104 includes a winding region 104a and an encapsulation region 104b, and the boundary of the first through hole 33 may be disposed in the winding region 104a.

Specifically, signal traces may be disposed in the winding region 104a, an organic encapsulation layer may be disposed in the winding region 104a, and the boundary of the organic encapsulation layer is located at a junction of the winding region 104a and the encapsulation region 104b.

Specifically, as shown in FIG. 5, an example in which the second gate layer 229 and the third gate layer 234 form signal traces in the winding region 104a is used for description in FIG. 5, but the embodiments of the invention are not limited thereto, and the signal traces in the winding region 104a may be disposed in one, two, or more metal layers (i.e., the gate layer and/or the source-drain layer) in the display panel.

Specifically, the signal trace may be a connection trace for transmitting signals of the scan line, the data line, and the power line, or may be a trace for transmitting other signals, which is not limited in the embodiments of the invention.

Specifically, since the organic encapsulation layer is not provided in the encapsulation region 104b, and the inorganic encapsulation layers are in direct contact with each other in the encapsulation region 104b, when the shrinkage rates of the film layers on the upper side are different, the inorganic encapsulation layer is prone to generate stress to cause the light-emitting layer to peel off. In the embodiments of the invention, by locating the boundary of the first through hole 33 in the winding region 104a, the stress generated by the inorganic layer caused by the different shrinkage rates of the film layers on the upper side can be avoided, the internal stress is reduced, the risk of peeling off the light-emitting layer is reduced, and the encapsulation performance of the display panel is improved.

Specifically, the boundary of the first through hole 33 may be disposed on a side of the boundary of the organic encapsulation layer close to the display region.

In some embodiments, as shown in FIG. 3 and FIG. 5, the second refractive index layer 282 is provided with the first through hole 33, and a boundary of the second refractive index layer 282 close to the functional region 103 is located between the retaining wall 32 and the display region 101, so that the stress conducted to the bottom film layer is reduced, the encapsulation performance of the display panel is improved, and the reliability of the display panel is improved.

In some embodiments, the material of the first refractive index layer 281 is different from the material of the second refractive index layer 282.

In some embodiments, the material of the second refractive index layer 282 is different from the material of the first light-shielding layer 291.

In some embodiments, the material of the second refractive index layer 282 is different from the material of the first planarization layer.

In some embodiments, the shrinkage rates of the first refractive index layer 281 and the second refractive index layer 282 are different in the same environment (such as in the same humidity and the same temperature environment).

In some embodiments, the shrinkage rates of the second refractive index layer 282 and the first light-shielding layer 291 are different in the same environment (such as in the same humidity and the same temperature environment).

In some embodiments, the shrinkage rates of the second refractive index layer 282 and the first planarization layer are different in the same environment (such as in the same humidity and the same temperature environment).

Specifically, to improve the light-emitting effect of the display panel, the first refractive index layer 281 and the second refractive index layer 282 are provided, and the shrinkage rate of the first refractive index layer 281 is different from that of the second refractive index layer 282, and the shrinkage rate of the second refractive index layer 282 is also different from that of other film layers, resulting in different deformation amounts of different film layers, which will form stress on the underlying inorganic layer and cause the light-emitting layer (which may be the light-emitting material layer, or the light-emitting material layer and the common electrode layer) at the retaining wall to be peeled off. However, in the embodiments of the invention, the second refractive index layer 282 is provided with the first through hole 33, and the boundary of the first through hole 33 is located between the retaining wall 32 and the display region 101, so that the stress concentration point can be avoided, the peeling of the light-emitting layer is avoided, the encapsulation performance of the display panel is improved, and the reliability of the display panel is improved.

Specifically, when the second refractive index layer 282 is provided with the first through hole 33, the position of the first through hole 33 may refer to the above embodiments, which will not be elaborated here.

In some embodiments, the distance between the boundary of the second refractive index layer 282 and the first retaining wall is less than or equal to the distance between the boundary of the second refractive index layer 282 and the display region.

In some embodiments, the distance between the boundary of the second refractive index layer 282 and the first retaining wall is greater than the distance between the boundary of the second refractive index layer 282 and the display region, so that stress concentration points can be further avoided, peeling of the light-emitting layer can be avoided, the encapsulation performance of the display panel can be improved, and the reliability of the display panel can be improved.

In some embodiments, the first light-shielding layer 291 is provided with a second through hole 341, the second through hole 341 penetrates the first light-shielding layer 291, and the boundary of the second through hole 341 is located on a side of the isolation column close to the display region 101, so that stress concentration points can be avoided, the risk of peeling off the light-emitting layer can be reduced, and the reliability of the display panel can be improved.

Specifically, in some display devices, the boundary of the first light-shielding layer 291 is located at the junction of the functional region 103 and the transition region 104, but the material of the first light-shielding layer 291 is different from that of the film layers on the upper and lower sides, which causes the shrinkage rate of the first light-shielding layer 291 to be different from that of the film layers on the upper and lower sides, resulting in the generation of stress on the inorganic layer of the bottom layer, thereby causing the light-emitting layer to peel off. In the embodiments of the invention, the boundary of the second through hole 341 is located on the side of the isolation column close to the display region 101, which can avoid stress concentration points, avoid peeling of the light-emitting layer, improve the encapsulation performance of the display panel, and improve the reliability of the display panel.

In some embodiments, the boundary of the second through hole 341 is located on a side of the first isolation column 311 close to the display region 101, so that stress concentration points can be further avoided, the risk of peeling off the light-emitting layer can be reduced, and the reliability of the display panel can be improved.

In some embodiments, the boundary of the second through hole 341 is located on a side of the second isolation column 312 close to the display region 101. In some embodiments, the boundary of the second through hole 341 is located between the second isolation column 312 and the first isolation column 311. In some embodiments, the boundary of the second through hole 341 is located above the second isolation column 312. In some embodiments, the boundary of the second through hole 341 is located above the first isolation column 311. In some embodiments, the boundary of the second through hole 341 is located between the isolation column and the retaining wall.

In some embodiments, as shown in FIG. 3 to FIG. 8B, the first light-shielding layer 291 is provided with a second through hole 341, the second through hole 341 is disposed in the functional region 103 and the transition region 104, and the boundary of the second through hole 341 is located on a side of the retaining wall 32 close to the display region 101. This avoids the problem that inconsistent shrinkage rates between the first light-shielding layer 291 and other film layers cause stress in the underlying inorganic layer and lead to peeling of the light-emitting layer, thereby improving the encapsulation performance and reliability of the display panel.

In some embodiments, the boundary of the second through hole 341 is located on a side of the second retaining wall 322 close to the display region, so that stress concentration points can be further avoided, the risk of peeling off the light-emitting layer can be reduced, and the reliability of the display panel can be improved.

In some embodiments, the boundary of the second through hole 341 is located on a side of the first retaining wall 321 close to the display region, so that stress concentration points can be further avoided, the risk of peeling off the light-emitting layer can be reduced, and the reliability of the display panel can be improved.

In some embodiments, the boundary of the second through hole 341 is located above the second retaining wall 322. In some embodiments, the boundary of the second through hole 341 is located between the second retaining wall 322 and the first retaining wall 321. In some embodiments, the boundary of the second through hole 341 is located between the first retaining wall 321 and the display region 101.

In some embodiments, as shown in FIG. 3 and FIG. 5 to FIG. 7, the boundary of the first light-shielding layer 291 may be located at the junction of the display region 101 and the transition region 104. In some embodiments, the boundary of the first light-shielding layer 291 may be located in the display region 101.

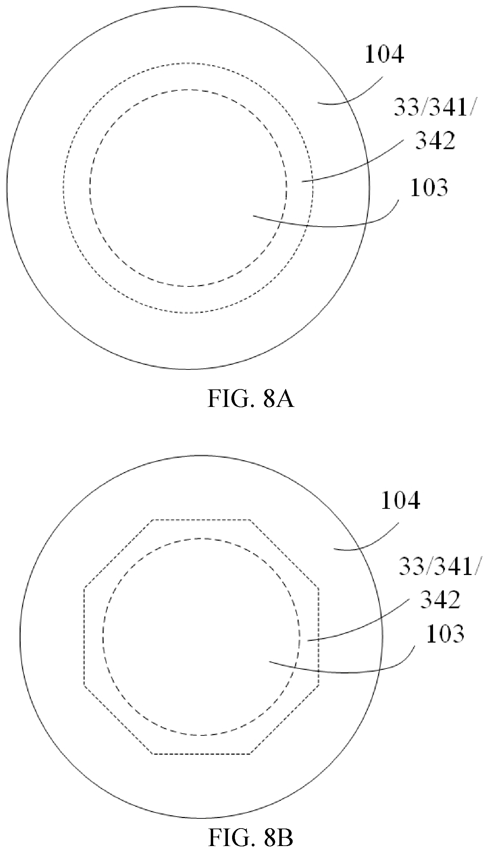

In some embodiments, as shown in FIG. 8A and FIG. 8B, the boundary of the first light-shielding layer 291 may be located in the transition region 104.

In some embodiments, the width of the first light-shielding portion 291a located at the junction of the display region 101 and the transition region 104 is greater than the width of the first light-shielding portion 291a located in the display region 101, so that the first light-shielding portion 291a can shield the edge of the display region 101 and may extend into the transition region for shielding light.

In some embodiments, the material of the first light-shielding layer 291 is different from the material of the first planarization layer.

In some embodiments, the shrinkage rates of the first light-shielding layer 291 and the first planarization layer are different in the same environment (such as in the same humidity and the same temperature environment).

In some embodiments, as shown in FIG. 3, the transition region 104 includes a winding region 104a and an encapsulation region 104b, and the boundary of the second through hole 341 may be disposed in the winding region 104a.

Specifically, since the organic encapsulation layer is not provided in the encapsulation region 104b, and the inorganic encapsulation layers are in direct contact with each other in the encapsulation region 104b, when the shrinkage rates of the film layers on the upper side are different, the inorganic encapsulation layer is prone to generate stress to cause the light-emitting layer to peel off. In the embodiments of the invention, by locating the boundary of the second through hole 341 in the winding region 104a, the stress generated by the inorganic layer caused by the different shrinkage rates of the film layers on the upper side can be avoided, the internal stress is reduced, the risk of peeling off the light-emitting layer is reduced, and the encapsulation performance of the display panel is improved.

Specifically, the boundary of the second through hole 341 may be disposed on a side of the boundary of the organic encapsulation layer close to the display region, or the boundary of the second through hole 341 is flush with the boundary of the organic encapsulation layer.

In some embodiments, the second light-shielding layer 294 is provided with a third through hole 342, the third through hole 342 penetrates the second light-shielding layer 294, and the boundary of the third through hole 342 is located on a side of the isolation column close to the display region 101, so that stress concentration points can be avoided, the risk of peeling off the light-emitting layer can be reduced, and the reliability of the display panel can be improved.

Specifically, in some display devices, the boundary of the second light-shielding layer 294 is located at the junction of the functional region 103 and the transition region 104, but the material of the second light-shielding layer 294 is different from that of the film layers on the upper and lower sides, which causes the shrinkage rate of the second light-shielding layer 294 to be different from that of the film layers on the upper and lower sides, resulting in the generation of stress on the inorganic layer of the bottom layer, thereby causing the light-emitting layer to peel off. In the embodiments of the invention, the boundary of the third through hole 342 is located on the side of the isolation column close to the display region 101, which can avoid stress concentration points, avoid peeling of the light-emitting layer, improve the encapsulation performance of the display panel, and improve the reliability of the display panel.

In some embodiments, the boundary of the third through hole 342 is located on a side of the first isolation column 311 close to the display region 101, so that stress concentration points can be further avoided, the risk of peeling off the light-emitting layer can be reduced, and the reliability of the display panel can be improved.

In some embodiments, the boundary of the third through hole 342 is located on a side of the second isolation column 312 close to the display region 101. In some embodiments, the boundary of the third through hole 342 is located between the second isolation column 312 and the first isolation column 311. In some embodiments, the boundary of the third through hole 342 is located above the second isolation column 312. In some embodiments, the boundary of the third through hole 342 is located above the first isolation column 311. In some embodiments, the boundary of the third through hole 342 is located between the isolation column and the retaining wall.

In some embodiments, as shown in FIG. 3 to FIG. 8B, the second light-shielding layer 294 is provided with a third through hole 342, the third through hole 342 is disposed in the functional region 103 and the transition region 104, and the boundary of the third through hole 342 is located on a side of the retaining wall 32 close to the display region 101. This avoids the problem that inconsistent shrinkage rates between the first light-shielding layer 291 and other film layers cause stress in the underlying inorganic layer and lead to peeling of the light-emitting layer, thereby improving the encapsulation performance and reliability of the display panel.

In some embodiments, the boundary of the third through hole 342 is located on a side of the second retaining wall 322 close to the display region, so that stress concentration points can be further avoided, the risk of peeling off the light-emitting layer can be reduced, and the reliability of the display panel can be improved.

In some embodiments, the boundary of the third through hole 342 is located on a side of the first retaining wall 321 close to the display region, so that stress concentration points can be further avoided, the risk of peeling off the light-emitting layer can be reduced, and the reliability of the display panel can be improved.

In some embodiments, the boundary of the third through hole 342 is located above the second retaining wall 322. In some embodiments, the boundary of the third through hole 342 is located between the second retaining wall 322 and the first retaining wall 321. In some embodiments, the boundary of the third through hole 342 is located between the first retaining wall 321 and the display region 101.

In some embodiments, as shown in FIG. 3 and FIG. 5 to FIG. 7, the boundary of the second light-shielding layer 294 may be located at the junction of the display region 101 and the transition region 104. In some embodiments, the boundary of the second light-shielding layer 294 may be located in the display region 101.

In some embodiments, as shown in FIG. 8A and FIG. 8B, the boundary of the second light-shielding layer 294 may be located in the transition region 104.

In some embodiments, the width of the second light-shielding portion 294a located at the junction of the display region 101 and the transition region 104 is greater than the width of the second light-shielding portion 294a located in the display region 101, so that the second light-shielding portion 294a can shield the edge of the display region 101 and may extend into the transition region for shielding light.

In some embodiments, the material of the second light-shielding layer 294 is different from the material of the first planarization layer. In some embodiments, the material of the second light-shielding layer 294 is different from the material of the second planarization layer.

In some embodiments, the shrinkage rates of the second light-shielding layer 294 and the first planarization layer are different in the same environment (such as in the same humidity and the same temperature environment). In some embodiments, the shrinkage rates of the second light-shielding layer 294 and the second planarization layer are different in the same environment (such as in the same humidity and the same temperature environment).

In some embodiments, as shown in FIG. 3, the transition region 104 includes a winding region 104a and an encapsulation region 104b, and the boundary of the third through hole 342 may be disposed in the winding region 104a.

Specifically, since the organic encapsulation layer is not provided in the encapsulation region 104b, and the inorganic encapsulation layers are in direct contact with each other in the encapsulation region 104b, when the shrinkage rates of the film layers on the upper side are different, the inorganic encapsulation layer is prone to generate stress to cause the light-emitting layer to peel off. In the embodiments of the invention, by locating the boundary of the third through hole 342 in the winding region 104a, the stress generated by the inorganic layer caused by the different shrinkage rates of the film layers on the upper side can be avoided, the internal stress is reduced, the risk of peeling off the light-emitting layer is reduced, and the encapsulation performance of the display panel is improved.

Specifically, the boundary of the third through hole 342 may be disposed on a side of the boundary of the organic encapsulation layer close to the display region, or the boundary of the third through hole 342 is flush with the boundary of the organic encapsulation layer.

In some embodiments, the isolation column 31 is disposed in the transition region 104, and the boundary of the first through hole 33 is located between the isolation column 31 and the functional region 103, so that the internal stress between adjacent film layers can be reduced, the internal stress conducted to the lower film layer can be reduced, the stress on the lower film layer can be reduced, and the risk of peeling off the light-emitting material layer and the common electrode layer can be reduced, thereby reducing the risk of water and oxygen intrusion, improving the encapsulation effect, and improving the reliability of the display panel.

In some embodiments, the first planarization layer 290 is provided with the first through hole 33, and the boundary of the first planarization layer 290 close to the functional region 103 is located in the transition region 104, so that the stress on the bottom film layer is reduced, the stress conducted to the bottom film layer is reduced, the encapsulation performance of the display panel is reduced, and the reliability of the display panel is improved.

In some embodiments, the material of the first planarization layer 290 is different from the material of the second planarization layer 295.

In some embodiments, the shrinkage rates of the first planarization layer 290 and the second planarization layer 295 are different in the same environment (such as in the same humidity and the same temperature environment).

Specifically, in order to achieve the anti-peeping display, the first light-shielding layer 291 and the second light-shielding layer 294 are provided, and in order to achieve the light-shielding effect at different angles, a first planarization layer needs to be provided between the first light-shielding layer 291 and the second light-shielding layer 294 to raise the second light-shielding layer 294. The shrinkage rate of the first planarization layer 290 is different from that of the adjacent film layers, resulting in different deformation amounts of different film layers, which will form stress on the lower inorganic layer and cause the light-emitting layer (which may be the light-emitting material layer, or the light-emitting material layer and the common electrode layer) at the retaining wall to be peeled off. However, in the embodiments of the invention, the first planarization layer 290 is provided with the first through hole 33, and the boundary of the first through hole 33 is located in the transition region 104, so that the stress concentration point can be avoided, the peeling of the light-emitting layer is avoided, the encapsulation performance of the display panel is improved, and the reliability of the display panel is improved.

Specifically, when the first planarization layer 290 is provided with the first through hole 33, the position of the first through hole 33 may refer to the above embodiments, which will not be elaborated here.

In some embodiments, the distance between the boundary of the first planarization layer 290 and the first retaining wall is less than or equal to the distance between the boundary of the first planarization layer 290 and the display region.

In some embodiments, the distance between the boundary of the first planarization layer 290 and the first retaining wall is greater than the distance between the boundary of the first planarization layer 290 and the display region, so that stress concentration points can be further avoided, peeling of the light-emitting layer can be avoided, the encapsulation performance of the display panel can be improved, and the reliability of the display panel can be improved.

In some embodiments, as shown in FIG. 3 to FIG. 7, the first planarization layer 290 includes a first sub-layer 292 and a second sub-layer 293, and the first sub-layer 292 is disposed between the first light-shielding layer 291 and the second sub-layer 293.

Specifically, when the first planarization layer 290 is provided, there may be a process limitation that the thickness of the first planarization layer 290 of the single-layer design cannot reach the required thickness, so that the first planarization layer 290 may include the first sub-layer 292 and the second sub-layer 293, and the sum of the thicknesses of the first sub-layer 292 and the second sub-layer 293 can reach the required thickness.

In some embodiments, the materials of the first sub-layer 292 and the second sub-layer 293 may be the same.

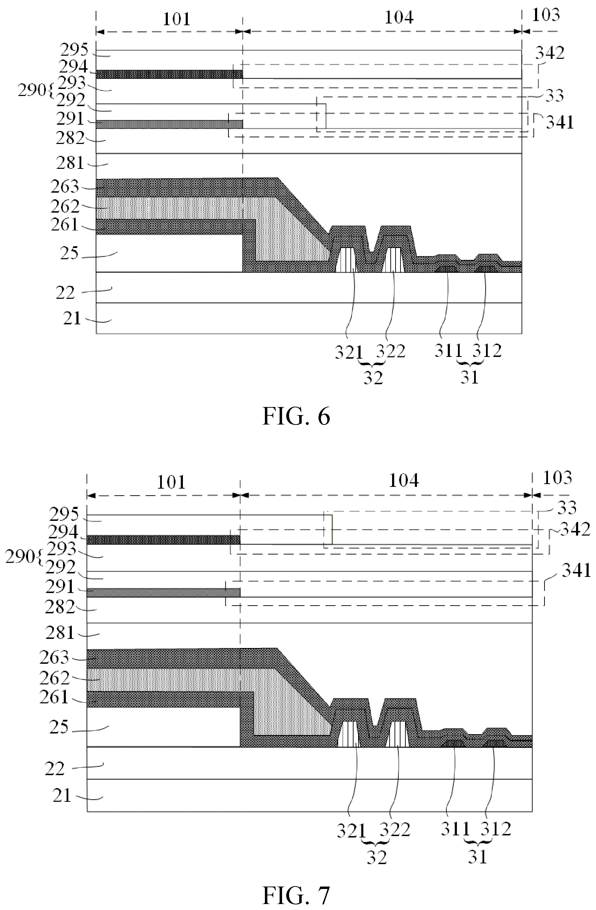

In some embodiments, as shown in FIG. 6, the first planarization layer 290 includes a first sub-layer 292 and a second sub-layer 293, and at least one of the first sub-layer 292 and the second sub-layer 293 is provided with the first through hole 33, so that the stress on the bottom film layer is reduced, the stress conducted to the bottom film layer is reduced, the encapsulation performance of the display panel is reduced, and the reliability of the display panel is improved.

In some embodiments, the material of the first sub-layer 292 is different from the material of the first light-shielding layer 291. In some embodiments, the material of the first sub-layer 292 is different from the material of the second refractive index layer 282. In some embodiments, the material of the first sub-layer 292 is different from the material of the second sub-layer 293.

In some embodiments, the shrinkage rates of the first sub-layer 292 and the first light-shielding layer 291 are different in the same environment (such as in the same humidity and the same temperature environment). In some embodiments, the shrinkage rates of the first sub-layer 292 and the second refractive index layer 282 are different in the same environment (such as in the same humidity and the same temperature environment). In some embodiments, the shrinkage rates of the first sub-layer 292 and the second sub-layer 293 are different in the same environment (such as in the same humidity and the same temperature environment).

In some embodiments, the first sub-layer 292 is provided with the first through hole 33, so that the internal stress between adjacent film layers can be reduced, the internal stress conducted to the lower film layer can be reduced, the stress on the lower film layer can be reduced, and the risk of peeling off the light-emitting material layer and the common electrode layer can be reduced, thereby reducing the risk of water and oxygen intrusion, improving the encapsulation effect, and improving the reliability of the display panel.

Specifically, when the first sub-layer 292 is provided with the first through hole 33, the position of the first through hole 33 may refer to the above embodiments, which will not be elaborated here.

In some embodiments, the material of the second sub-layer 293 is different from the material of the second light-shielding layer 294. In some embodiments, the material of the second sub-layer 293 is different from the material of the second planarization layer 295.

In some embodiments, the shrinkage rates of the second sub-layer 293 and the second light-shielding layer 294 are different in the same environment (such as in the same humidity and the same temperature environment). In some embodiments, the shrinkage rates of the second sub-layer 293 and the second planarization layer 295 are different in the same environment (such as in the same humidity and the same temperature environment).

Specifically, when the second sub-layer 293 is provided with the first through hole 33, the position of the first through hole 33 may refer to the above embodiments, which will not be elaborated here.

Specifically, the first sub-layer 292 and the second sub-layer 293 may be each provided with the first through hole 33, and the first through hole of the first sub-layer 292 may coincide with the first through hole of the second sub-layer 293, or the first through hole of the first sub-layer 292 may not coincide with the first through hole of the second sub-layer 293.

In some embodiments, as shown in FIG. 7, the second planarization layer 295 is provided with the first through hole 33, and the boundary of the second planarization layer 295 close to the functional region 103 is located in the transition region, so that the stress on the bottom film layer is reduced, the stress conducted to the bottom film layer is reduced, the encapsulation performance of the display panel is reduced, and the reliability of the display panel is improved.

Specifically, in order to achieve the anti-peeping display, the first light-shielding layer 291 and the second light-shielding layer 294 are provided, and in order to be planarized, the second planarization layer 295 is provided, and the shrinkage rate of the second planarization layer 295 is different from that of the adjacent film layers, resulting in different deformation amounts of different film layers, which will form stress on the lower inorganic layer and cause the light-emitting layer (which may be the light-emitting material layer, or the light-emitting material layer and the common electrode layer) at the retaining wall to be peeled off. However, in the embodiments of the invention, the second planarization layer 295 is provided with the first through hole 33, and the boundary of the first through hole 33 is located in the transition region 104, so that the stress concentration point can be avoided, the peeling of the light-emitting layer is avoided, the encapsulation performance of the display panel is improved, and the reliability of the display panel is improved.

Specifically, when the second planarization layer 295 is provided with the first through hole 33, the position of the first through hole 33 may refer to the above embodiments, which will not be elaborated here.

In some embodiments, the distance between the boundary of the second planarization layer 295 and the first retaining wall is less than or equal to the distance between the boundary of the second planarization layer 295 and the display region.

In some embodiments, the distance between the boundary of the second planarization layer 295 and the first retaining wall is greater than the distance between the boundary of the second planarization layer 295 and the display region, so that stress concentration points can be further avoided, peeling of the light-emitting layer can be avoided, the encapsulation performance of the display panel can be improved, and the reliability of the display panel can be improved.

In some embodiments, as shown in FIG. 8A and FIG. 8B, the shape of the first through hole 33 includes one of a rectangle, a square, a circle, and a polygon.

Specifically, the shape of the first through hole 33 may be the same as the shape of the functional region; and the shape of the first through hole 33 may be the same as the shape of the outer edge of the transition region.

Specifically, as shown in FIG. 8A, it can be seen that the shape of the first through hole 33 is a circle, and as shown in FIG. 8B, it can be seen that the shape of the first through hole 33 is an octagon.

In some embodiments, as shown in FIG. 8A and FIG. 8B, the shape of the second through hole 341 includes one of a rectangle, a square, a circle, and a polygon.

In some embodiments, as shown in FIG. 8A and FIG. 8B, the shape of the third through hole 342 includes one of a rectangle, a square, a circle, and a polygon.

In some embodiments, as shown in FIG. 3, FIG. 5 to FIG. 7, and FIG. 9, the first light-shielding layer 291 is disposed on a side of the second refractive index layer 282 away from the first refractive index layer 281. The first planarization layer 290 is disposed on a side of the first light-shielding layer 291 away from the second refractive index layer 282. The second light-shielding layer 294 is disposed on a side of the first planarization layer 290 away from the first light-shielding layer 291. The second planarization layer 295 is disposed on a side of the second light-shielding layer 294 away from the first planarization layer 290.

Specifically, when the dimming functional layer 28 is disposed close to the encapsulation layer 26, at least one of the second refractive index layer 282, the first planarization layer 290, and the second planarization layer 295 may be provided with the first through hole 33.

Specifically, when the dimming functional layer 28 is disposed close to the encapsulation layer 26, the dimming functional layer 28 is more likely to generate stress on the encapsulation layer 26 and the light-emitting layer, and the stress is large, so that the stress on the encapsulation layer 26 and the light-emitting layer can be reduced by providing the first through hole 33 in the dimming functional layer 28, thereby improving the encapsulation effect.

In some embodiments, as shown in FIG. 3 and FIG. 5, the second refractive index layer 282 is provided with the first through hole 33, the first planarization layer 290 fills the first through hole 33, and the thickness H1 of a portion of the first planarization layer 290 corresponding to the first through hole 33 is greater than the thickness H2 of other portions of the first planarization layer 290, so that the first planarization layer 290 fills the first through hole 33 of the second refractive index layer 282, and the first planarization layer 290 can fill and level the first through hole 33 to facilitate subsequent film layer formation.

In some embodiments, as shown in FIG. 10, the first light-shielding layer 291 is disposed between the first planarization layer 290 and the substrate 21. The dimming functional layer 28 is disposed on a side of the first planarization layer 290 away from the first light-shielding layer 291. The second light-shielding layer 294 is disposed on a side of the dimming functional layer 28 away from the first planarization layer 290. The second planarization layer 295 is disposed on a side of the second light-shielding layer 294 away from the dimming functional layer 28.

Specifically, when the dimming functional layer 28 is disposed away from the encapsulation layer 26, at least one of the second refractive index layer 282, the first planarization layer 290, and the second planarization layer 295 may be provided with the first through hole 33.

In some embodiments, as shown in FIG. 11, the second refractive index layer 282 is provided with the first through hole 33, and a portion of the second planarization layer 295 fills the first through hole 33, and the thickness H3 of a portion of the second planarization layer 295 corresponding to the first through hole 33 is greater than the thickness H4 of other portions of the second planarization layer 295, so that the second planarization layer 295 fills the first through hole 33 of the second refractive index layer 282, and the second planarization layer 295 can fill and level the first through hole 33 to facilitate subsequent film layer formation or attachment.

Specifically, when the dimming functional layer 28 is disposed away from the encapsulation layer 26, the shrinkage rate of the dimming functional layer 28 is different from that of the adjacent film layers, so that the dimming functional layer 28 may be provided with the first through hole 33, thereby reducing the stress on the encapsulation layer 26 and the light-emitting layer, and improving the encapsulation effect.

Specifically, as shown in FIG. 3 to FIG. 7, the display panel 1 may not be provided with the third light-shielding layer 351, the color resist layer 352, and the third planarization layer 353. As shown in FIG. 9 and FIG. 10, the display panel may be provided with a third light-shielding layer 351, a color resist layer 352, and a third planarization layer 353.

Specifically, when the display panel is provided with the third light-shielding layer 351, the third light-shielding layer 351 may be provided with a via hole, the via hole is located at least in the functional region, and the arrangement of the via hole may refer to the arrangement of the second through hole in the above embodiments, which will not be elaborated here.

Specifically, when the display panel is provided with a third planarization layer 353, the third planarization layer 353 may be provided with the first through hole, and the arrangement of the first through hole may refer to the arrangement of the first through hole in the above embodiments, which will not be elaborated here.

In some embodiments, as shown in FIG. 3, FIG. 5, and FIG. 11, the second refractive index layer 282 is provided with the first through hole 33. The boundary of the second refractive index layer 282 is disposed on the side of the boundary of the first light-shielding layer 291 close to the functional region 103, and is disposed on the side of the boundary of the second light-shielding layer 294 close to the functional region 103, so that while the second refractive index layer 282 is provided with the first through hole 33 to reduce the risk of peeling off the light-emitting layer, the boundaries of the first light-shielding layer 291 and the second light-shielding layer 294 can still be within the boundary of the dimming functional layer 28, and the effects of avoiding light leakage and improving the light-emitting efficiency through the dimming functional layer 28 can still be achieved. In some embodiments, as shown in FIG. 2, the display panel 1 includes anti-peeping sub-pixels 15 and non-anti-peeping sub-pixels 14. The first light-shielding layer 291 includes first light-shielding portions 291a, the second light-shielding layer 294 includes second light-shielding portions 294a, at least two sides of the anti-peeping sub-pixel 15 are each provided with a first light-shielding portion 291a and a second light-shielding portion 294a, and at least one side of the non-anti-peeping sub-pixel 14 is not provided with the second light-shielding portion 294a.

The first refractive index layer 281 includes light-transmitting openings 281a, and each light-transmitting opening 281a is disposed corresponding to the anti-peeping sub-pixel 15 or the non-anti-peeping sub-pixel 14, thereby improving the transmittance of the display panel.

Specifically, as shown in FIG. 2, in the projection on the substrate, the distance between the first light-shielding portion 291a and the anti-peeping sub-pixel is less than or equal to the distance between the second light-shielding portion 294a and the anti-peeping sub-pixel.

Specifically, the light-emitting material layer 253 includes non-anti-peeping light-emitting portions 253a each corresponding to a non-anti-peeping sub-pixel and anti-peeping light-emitting portions 253b each corresponding to an anti-peeping sub-pixel. The non-anti-peeping light-emitting portions 253a include light-emitting portions corresponding one-to-one to the first non-anti-peeping sub-pixels 111, the second non-anti-peeping sub-pixels 112, and the third non-anti-peeping sub-pixels 113. The anti-peeping light-emitting portions 253b include light-emitting portions corresponding one-to-one to the first anti-peeping sub-pixels 121, the second anti-peeping sub-pixels 122, and the third anti-peeping sub-pixels 123. Each light-transmitting opening 281a is disposed corresponding to a non-anti-peeping light-emitting portion 253a or an anti-peeping light-emitting portion 253b.

Specifically, in the above embodiment, the first through hole, the second through hole, or the third through hole is formed in corresponding film layers as an example, it can be understood that the plurality of film layers may be each provided with the through hole, for example, the second refractive index layer and the first planarization layer may be each provided with the through hole, and the boundaries of the through holes may or may not overlap, which will not be elaborated here.

Specifically, in the embodiments of the invention, that a certain film layer is provided with a through hole means that the portion of the film layer located in the region corresponding to the through hole is removed (or etched) during the preparation process. For example, the second refractive index layer 282 is provided with the first through hole 33, and the boundary of the first through hole 33 is located in the transition region, which means that the portion of the second refractive index layer 282 located in the functional region is removed, and the portion of the second refractive index layer 282 located in the transition region corresponding to the first through hole 33 is removed. Similarly, the meaning of other film layers provided with through holes can be determined, which will not be elaborated here.

Specifically, for the design of the functional region, the embodiments of the invention are not limited, for example, some film layers of the driving circuit layer in the functional region may be removed, or all film layers from the second planarization layer to the buffer layer in the functional region may be removed. Alternatively, all film layers from the second planarization layer to the substrate in the functional region are removed.

Specifically, the display panel in the above embodiments is described in detail from the aspects of regional division, film layer design, pixel arrangement of the display panel and so on. It can be understood that when there is no conflict among the respective embodiments, the respective embodiments may be combined. For example, the second refractive index layer is provided with a first through hole, and the first planarization layer is also provided with a first through hole.

Furthermore, embodiments of the invention provide a display device, which includes the display panel as described in any of the above embodiments.

Specifically, the display device further includes a functional element disposed in the functional region.

Specifically, the display device further includes structures such as a power supply and a housing.

In the description of the invention, the terms "first" and "second" are used solely for descriptive purposes and should not be understood as indicating or implying relative importance or the number of indicated technical features. Thus, features denoted by "first" and "second" may expressly or implicitly include one or a plurality of features. In the description of the invention, multiple means two or more, unless otherwise specifically defined.

In the above embodiments, different parts of the technical solution are given different levels of description in different embodiments, and some features that are not specified in a particular embodiment can be found in the relevant descriptions of other embodiments.

The embodiments, implementations and related technical features of the invention can be combined and replaced with each other without conflict.

What described above are only preferred embodiments of the invention and are not intended to limit the invention in any form. Any simple modification, equivalent change and embellishment to the above embodiments based on the technical essence of the invention without departing from the content of the technical solution of the invention still fall within the scope of the technical solution of the invention.

## Claims

1. A display panel (1), comprising a display region (101), a functional region (103), and a transition region (104), the transition region (104) being disposed between the display region (101) and the functional region (103); wherein the display panel (1) comprises a substrate (21) and a dimming functional layer (28), a first light-shielding layer (291), a first planarization layer (290), a second light-shielding layer (294), and a second planarization layer (295) that are disposed on a side of the substrate (21), the dimming functional layer (28) comprises a first refractive index layer (281) and a second refractive index layer (282), the first refractive index layer (281) is disposed between the substrate (21) and the second refractive index layer (282), and a refractive index of the first refractive index layer (281) is smaller than a refractive index of the second refractive index layer (282);
wherein at least one of the second refractive index layer (282), the first planarization layer (290) and the second planarization layer (295) is provided with a first through hole (33), the first through hole (33) is disposed in the functional region (103) and the transition region (104), and a boundary of the first through hole (33) is located in the transition region (104).

2. The display panel (1) of claim 1, further comprising an isolation column (31), wherein the isolation column (31) comprises an undercut structure, the isolation column (31) is disposed in the transition region (104), and the boundary of the first through hole (33) is located between the isolation column (31) and the display region (101).

3. The display panel (1) of claim 2, wherein the isolation column (31) comprises a first isolation column (311) and a second isolation column (312), the first isolation column (311) is disposed between the second isolation column (312) and the display region (101), and the boundary of the first through hole (33) is located between the first isolation column (311) and the display region (101).

4. The display panel (1) of claim 2, further comprising a retaining wall (32), wherein the retaining wall (32) is disposed in the transition region (104), the retaining wall (32) is located between the isolation column (31) and the display region (101), and the boundary of the first through hole (33) is located between the retaining wall (32) and the display region (101).

5. The display panel (1) of claim 4, wherein the retaining wall (32) comprises a first retaining wall (321) and a second retaining wall (322), the first retaining wall (321) is disposed between the second retaining wall (322) and the display region (101), and the boundary of the first through hole (33) is located between the first retaining wall (321) and the display region (101).

6. The display panel (1) of claim 4, wherein the second refractive index layer (282) is provided with the first through hole (33), and a boundary of the second refractive index layer (282) close to the functional region (103) is located between the retaining wall (32) and the display region (101).

7. The display panel (1) of claim 4, wherein the first light-shielding layer (291) is provided with a second through hole (341), the second through hole (341) is disposed in the functional region (103) and the transition region (104), and a boundary of the second through hole (341) is located on a side of the retaining wall (32) close to the display region (101).

8. The display panel (1) of claim 4, wherein the second light-shielding layer (294) is provided with a third through hole (342), the third through hole (342) is disposed in the functional region (103) and the transition region (104), and a boundary of the third through hole (342) is located on a side of the retaining wall (32) close to the display region (101).

9. The display panel (1) of claim 1, wherein at least one of the following conditions is satisfied:
the display panel (1) further comprises an isolation column (31), wherein the isolation column (31) comprises an undercut structure, the isolation column (31) is disposed in the transition region (104), and the boundary of the first through hole (33) is located between the isolation column (31) and the functional region (103); and
the first through hole (33) has a shape selected from a rectangle, a square, a circle, and a polygon.

10. The display panel (1) of claim 1, wherein the first planarization layer (290) is provided with the first through hole (33), and a boundary of the first planarization layer (290) close to the functional region (103) is located in the transition region (104).

11. The display panel (1) of claim 10, wherein the first planarization layer (290) comprises a first sub-layer (292) and a second sub-layer (293), and at least one of the first sub-layer (292) and the second sub-layer (293) is provided with the first through hole (33).

12. The display panel (1) of claim 1, wherein at least one of the following conditions is satisfied:
the second planarization layer (295) is provided with the first through hole (33), and a boundary of the second planarization layer (295) close to the functional region (103) is located in the transition region (104); and
the second refractive index layer (282) is provided with the first through hole (33), a boundary of the second refractive index layer (282) is disposed on a side of a boundary of the first light-shielding layer (291) close to the functional region (103), and on a side of a boundary of the second light-shielding layer (294) close to the functional region (103).

13. The display panel (1) of claim 1, wherein the first light-shielding layer (291) is disposed on a side of the second refractive index layer (282) away from the first refractive index layer (281); the first planarization layer (290) is disposed on a side of the first light-shielding layer (291) away from the second refractive index layer (282); the second light-shielding layer (294) is disposed on a side of the first planarization layer (290) away from the first light-shielding layer (291); and the second planarization layer (295) is disposed on a side of the second light-shielding layer (294) away from the first planarization layer (290); wherein the second refractive index layer (282) is provided with the first through hole (33), a portion of the first planarization layer (290) fills the first through hole (33), and a thickness of the portion of the first planarization layer (290) corresponding to the first through hole (33) is greater than a thickness of other portions of the first planarization layer (290); or
wherein the first light-shielding layer (291) is disposed between the first planarization layer (290) and the substrate (21), the dimming functional layer (28) is disposed on a side of the first planarization layer (290) away from the first light-shielding layer (291), the second light-shielding layer (294) is disposed on a side of the dimming functional layer (28) away from the first planarization layer (290), and the second planarization layer (295) is disposed on a side of the second light-shielding layer (294) away from the dimming functional layer (28); wherein the second refractive index layer (282) is provided with the first through hole (33), a portion of the second planarization layer (295) fills the first through hole (33), and a thickness of the portion of the second planarization layer (295) corresponding to the first through hole (33) is greater than a thickness of other portions of the second planarization layer (295).

14. The display panel (1) of any one of claims 1 to 13, wherein the display panel (1) comprises a plurality of anti-peeping sub-pixels (15) and a plurality of non-anti-peeping sub-pixels (14), the first light-shielding layer (291) comprises a plurality of first light-shielding portions (291a), the second light-shielding layer (294) comprises a plurality of second light-shielding portions (294a), at least two sides of each of the anti-peeping sub-pixels (15) are each provided with one of the first light-shielding portions (291a) and one of the second light-shielding portions (294a), and at least one side of each of the non-anti-peeping sub-pixels (14) is not provided with any of the second light-shielding portions (294a);
wherein the first refractive index layer (281) comprises a plurality of light-transmitting openings (281a), and each of the light-transmitting openings (281a) is disposed corresponding to a respective one of the anti-peeping sub-pixels (15) or a respective one of the non-anti-peeping sub-pixels (14).

15. A display device, comprising the display panel (1) as claimed in any one of claims 1 to 14.
